# NOUVEAU FASCICULE DE BREVET EUROPEEN

(11) **EP 0 249 511 B2**
(45) Date de publication et mention de la décision concernant l'opposition: **22.12.1993**
(45) Mention de la délivrance du brevet: 20.06.1990
(21) Numéro de dépôt: 87400341.1
(22) Date de dépôt: 17.02.1987
(51) Int. Cl.: G01D 13/22

(54) **Dispositif indicateur à aiguille et canon d'indexage pour celui-ci**
Anzeigeapparat mit Zeiger und Indexierungshülse dafür
Indicator with a needle and locating collar therefor

(30) Priorité: 18.02.1986 FR 8602153
(43) Date de publication de la demande: 16.12.1987
(73) Titulaire: JAEGER, F-92303 Levallois-Perret (FR)
(72) Inventeur: Lazareff, André, F92110 Clichy (FR)
(74) Mandataire: Martin, Jean-Jacques

(56) Documents cités:
- DE-A- 3 425 029
- DE-A- 3 435 377
- GB-A- 1 556 284
- US-A- 2 939 731
- US-A- 3 719 378

## Description

La présente invention concerne le domaine des dispositifs indicateurs à aiguille du type comprenant un élément moteur muni d'un arbre de sortie déplacé en pivotement autour de son axe de façon contrôlée en fonction d'un paramètre à visualiser et un canon intermédiaire intercalé entre l'arbre de sortie et l'aiguille pour entraîner l'aiguille à rotation en correspondance à la rotation de l'arbre de sortie.

Différents dispositifs indicateurs à aiguille de ce type ont déjà été proposés.

Le document DE-A-3425029 décrit par exemple un dispositif indicateur à aiguille comprenant un élément moteur muni d'un arbre de sortie déplacé en pivotement autour de son axe, de façon contrôlée, en fonction d'un paramètre à visualiser, et une aiguille solidaire d'un canon intermédiaire par l'intermédiaire duquel l'aiguille peut être fixée sur l'arbre de sortie. Le document DE-A-3425029 décrit surtout diverses structures de prismes ou équivalents sur le canon intermédiaire et dans le corps de l'aiguille, conçues pour dévier des rayons lumineux introduits dans le canon, afin d'éclairer, l'aiguille sensiblement sur toute sa longueur.

Le document GB-A-1556284 décrit un autre dispositif indicateur à aiguille comprenant un élément moteur muni d'un arbre de sortie, un canon intermédiaire ayant la forme générale d'un disque conçu pour être fixé sur l'arbre de sortie, et une aiguille solidaire d'une collerette adaptée pour être fixée sur le canon intermédiaire.

Le document DE-A-3435377 décrit un dispositif indicateur à aiguille comprenant un élément moteur muni d'un arbre de sortie déplacé en pivotement autour de son axe, de façon contrôlée, en fonction d'un paramètre à visualiser, une aiguille, un élément intermédiaire intercalé entre l'arbre de sortie de l'élément moteur et l'aiguille, ledit élément intermédiaire comprenant un fût muni d'un alésage par lequel l'élément intermédiaire est chassé sur l'arbre de sortie de l'élément moteur et une portion non symétrique de révolution par rapport à l'axe de l'alésage et destinée à coopérer avec l'aiguille pour définir un indexage angulaire de celle-ci par rapport à l'arbre. Le dispositif indicateur à aiguille décrit dans le document DE-A-3435377 comprend un élément intermédiaire de forme complexe qui comporte un barreau transversal au fût et qui porte à chacune de ses extrémités des joues latérales. Celles-ci définissent en combinaison avec le barreau, une cavité conçue pour recevoir le talon complémentaire de l'aiguille. Chacune des joues latérales est par ailleurs munie d'un logement destiné à recevoir un tourillon porté par le talon de l'aiguille. L'engagement de l'aiguille sur l'élément intermédiaire est ainsi réalisé selon un mouvement complexe qui consiste à introduire le talon de l'aiguille dans la cavité, dans une position générale axiale pour engager les tourillons dans les logements, puis à pivoter l'aiguille en position radiale d'utilisation. Le document DE-A-3435377 enseigne en outre un capuchon de fixation de l'aiguille sur l'élément intermédiaire. Le capuchon est conçu pour recouvrir la totalité du talon de l'aiguille et l'élément intermédiaire. Comme cela est représenté clairement sur la figure 5, le capuchon est muni dans sa paroi périphérique de cavités conçues pour recevoir des dents élastiques prévues sur les joues latérales de l'élément intermédiaire. Le capuchon est par conséquent engagé, par translation axiale, sur le talon de l'aiguille. La fixation de l'aiguille est obtenue lorsque les dents élastiques de l'élément intermédiaire pénètrent dans les cavités du capuchon. Un tel engagement entre l'élément intermédiaire et le capuchon exige l'emploi d'un outil complexe représenté sur les figures 9 à 12 pour retirer l'aiguille. Plus précisément l'outil représenté sur les figures 9 à 12 est destiné à escamoter les dents élastiques pour autoriser le retrait du capuchon avant de permettre le basculement de l'aiguille en position axiale et le retrait de cette dernière.

L'un des buts de la présente invention est de proposer des moyens permettant un démontage simple et rapide et l'aiguille tout en conservant une indexation angulaire sur l'arbre de sortie de l'élément moteur en vue d'un repositionnement ultérieur de l'aiguille sur l'arbre de l'élément moteur.

Un autre but de la présente invention est de proposer des moyens permettant un indexage angulaire précis et fiable de l'aiguille par rapport à l'arbre de sortie de l'élément moteur.

Un autre but de la présente invention est de proposer des moyens permettant de réaliser un indexage angulaire sur l'arbre de sortie de l'élément moteur, sur une chaîne de montage en série.

Un autre but de la présente invention est de proposer des moyens permettant d'assembler au choix, de façon simple et rapide et avec indexation angulaire précise, différents modèles d'aiguille sur un élément moteur standard, ou inversement une aiguille standard sur différents modèles d'élément moteur.

Ces différents buts sont atteints, selon la présente invention, grâce à un dispositif indicateur à aiguille du type comprenant un élément moteur muni d'un arbre de sortie déplacé en pivotement autour de son axe de façon contrôlée en fonction d'un paramètre à visualiser, une aiguille, et un élément intermédiaire intercalé entre l'arbre de sortie de l'élément moteur et l'aiguille, ledit élément intermédiaire comprenant un fût muni d'un alésage par lequel l'élément intermédiaire est chassé sur l'arbre de sortie de l'élément moteur, et une portion non symétrique de révolution par rapport à l'axe de l'alésage et destinée à coopérer avec l'aiguille pour définir un indexage angulaire de celle-ci par rapport à l'arbre, caractérisé par le fait que : a) - l'élément intermédiaire à la forme d'un canon, b) - l'aiguille comprend un alésage non symétrique de révolution, sensiblement complémentaire de la portion non symétrique de révolution prévue sur le canon, c) - la portion non symétrique de révolution prévue sur le canon comprend une structure élastique s'étendant sensiblement parallèlement à l'axe de l'arbre, ladite structure élastique étant conçue pour être engagée élastiquement dans l'alésage complémentaire de l'aiguille par translation relative selon l'axe de l'arbre, et d) - l'alésage formé dans le fût du canon définissant un engagement serré par friction du canon sur l'arbre de sortie qui correspond à une force de maintien supérieure à la force de maintien définie par la structure élastique dans l'alésage complémentaire de l'aiguille.

La partie dite de clavetage non symétrique de révolution du canon possède avantageusement une enveloppe choisie dans le groupe comprenant: un carré, un tronc à méplat, un tronc cannelé.

Selon une caractéristique avantageuse de la présente invention, la portion de clavetage est formée d'au moins deux languettes élastiques, chacune de celles-ci étant de préférence munie à proximité de son extrémité libre d'une dent en saillie vers l'extérieur.

D'autres caractéristiques, buts et avantages de la présente invention apparaîtront à la lecture de la description détaillée qui va suivre et en regard des dessins annexés donnés à titre d'exemple non limitatif et sur lesquels:
la figure 1 représente une vue d'ensemble d'un appareil indicateur à aiguille conforme à la présente invention,
la figure 2 représente une vue latérale, partiellement en coupe, d'un canon conforme à la présente invention,
la figure 3 représente une autre vue latérale du même canon, selon une vue orthogonale à celle de la figure 2,
la figure 4 représente une vue de dessus du canon d'indexage,
la figure 5 représente une vue de dessous d'une aiguille, et
la figure 6 représente une vue en coupe longitudinale de la même aiguille selon un plan de coupe référencé VI-VI sur la figure 5.

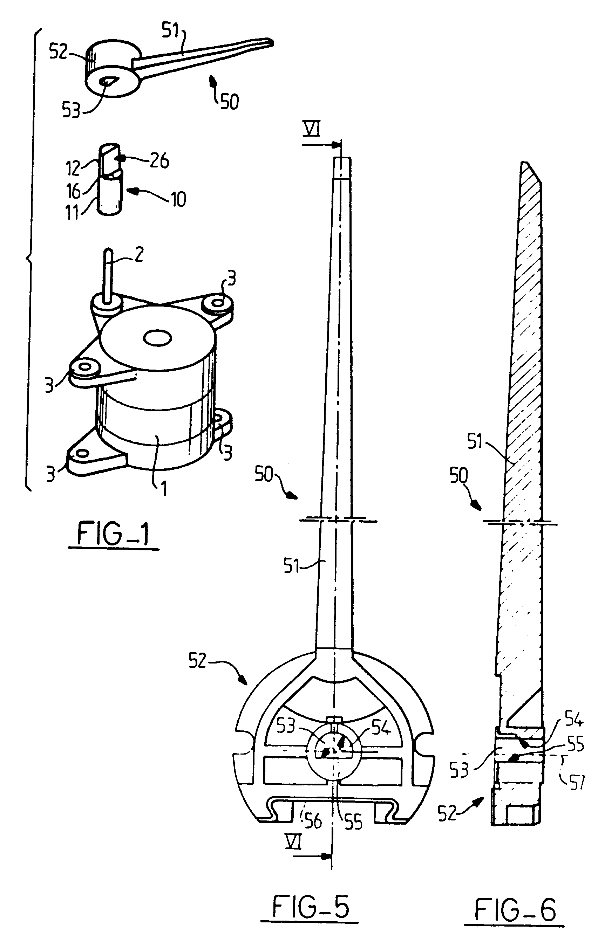

Sur la figure 1 annexée on distingue l'élément monteur 1 d'un appareil indicateur, dont l'arbre de sortie 2 est déplacé en pivotement autour de son axe, de façon contrôlée en fonction d'un paramètre à visualiser.

On distingue également sur cette figure 1 un canon intermédiaire d'indexage 10 adapté pour être chassé sur l'arbre 2, ainsi qu'une aiguille 50.

La structure de l'élément moteur 1, classique en soi ne sera pas décrite en détail par la suite.

L'élément moteur est fixé sur un support (non représenté sur les figures pour simplifier l'illustration) par tous moyens appropriés, par exemple par des pattes munies d'oeillets 3.

L'arbre 2 est d'une façon générale formé d'une tige cylindrique symétrique de révolution et de section constante.

La commande d'entraînement de l'élément moteur 1 liée au paramètre à visualiser, et destinée à induire une rotation de l'arbre 2 autour de son axe sur un amplitude angulaire dépendant de l'amplitude du paramètre à visualiser peut être du type mécanique ou électrique.

L'élément moteur 1 peut être formé par exemple d'un galvanomètre ou d'un mouvement d'horlogerie.

Le problème essentiel posé dans le cadre de la présente invention est de réaliser un indexage angulaire précis et fiable de l'aiguille 50 par rapport à l'arbre de sortie 2 de l'élément moteur, de telle sorte que la position angulaire de l'aiguille 50 corresponde à une information précise et exploitable.

Comme indiqué précédemment, dans le cadre de la présente invention, cet indexage angulaire est réalisé grâce à un canon 10 intermédiaire entre l'arbre 2 et l'aiguille 50.

Le canon 10 possède un fût cylindrique 11 muni d'un alésage 12 par l'intermédiaire duquel le canon 10 est chassé sur l'arbre 2. Le canon 10 est de plus muni d'une portion 20 ce clavetage de l'aiguille 50, non symétrique de révolution par rapport à l'axe 13 de l'alésage 12. La portion 20 de clavetage peut prendre différentes formes, telles que tronc muni d'un méplat, carré, tronc muni de cannelures s'étendant parallèlement à l'axe 13...

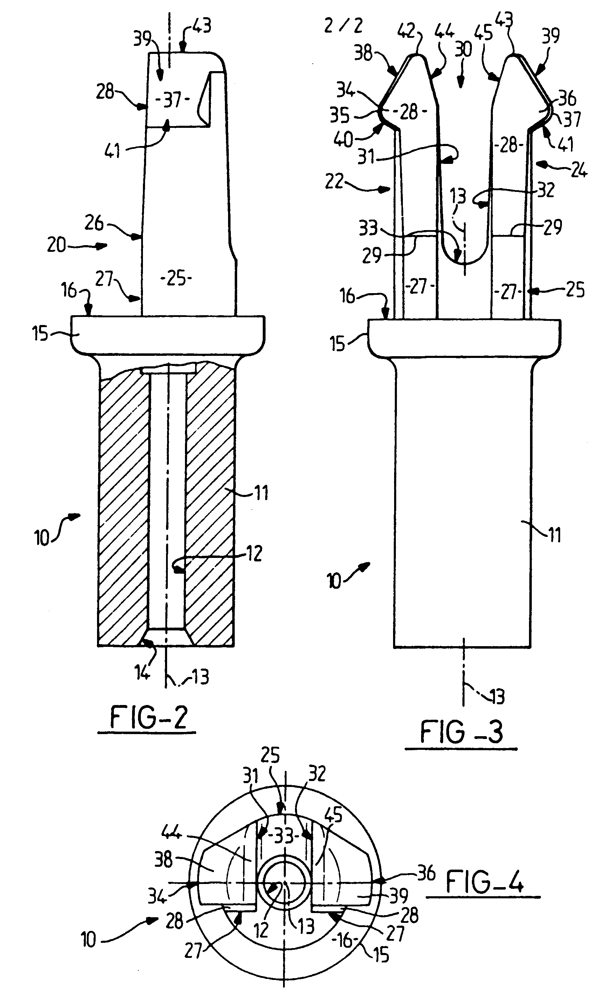

Le cas échéant, et pour faciliter l'insertion de la partie de clavetage 20 dans l'aiguille 50, cette portion de clavetage 20 peut être formée de différentes languettes s'étendant sensiblement parallèlement à l'axe 13 de l'alésage 12 et présentant une certaine élasticité. Cette disposition, représentée par exemple sur les figures 2 à 4, sera décrite plus en détail par la suite.

De préférence, le canon d'indexage 10 possède un décrochement 16 s'étendant perpendiculairement à l'axe 13 de l'alésage 12 et dirigé vers l'extrémité libre de la portion de clavetage 20. Ce décrochement 16 sert de butée pour l'aiguille 50.

L'aiguille 50 se compose pour l'essentiel d'un corps indicateur effilé 51 solidaire par son extrémité la plus large d'un moyeu 52.

Ce dernier présente un alésage 53 qui s'étend d'une façon générale perpendiculairement à la direction d'élongation du corps indicateur 51. L'alésage 53 possède une enveloppe non symétrique de révolution sensiblement complémentaire de l'enveloppe de la portion de clavetage 20 prévue sur le canon d'indexage 10.

Les dimensions de l'alésage 12, considérées en section droite, c'est-à-dire transversalement à l'axe 13, par rapport aux dimensions en section droite de l'arbre de sortie 2 sont adaptées pour définir un engagement serré par friction du canon d'indexage 10 sur l'arbre de sortie 2, autorisant une rotation relative entre ces éléments, autour de l'axe 13 de l'alésage, coîncidant avec l'axe de l'arbre 2, lorsque un couple suffisant est exercé sur le canon 10, tout en interdisant une rotation libre du canon d'indexage 10 par rapport à l'arbre de sortie 2.

De préférence, pour réaliser un tel engagement serré, l'alésage 12 est légèrement évasé vers son extrémité libre (vers le bas selon l'illustration de la figure 2).

Pour utiliser un tel canon d'indexage 10 il suffit de positionner l'élément moteur 1 par rapport à un cadran repère, de chasser le canon 10 sur l'arbre 2 et d'engager une aiguille 50 sur la portion 20 de clavetage du canon, puis de déplacer l'aiguille par rotation autour de l'axe 13, en regard d'un index approprié prévu sur le cadran repère et correspondant à la position angulaire appropriée de l'aiguille correspondant à l'état de l'élément moteur (par exemple une position de repos, ou bien une position de travail contrôlée et connue avec précision).

Au cours de cette rotation autour de l'axe 13, l'aiguille 50 étant liée à rotation avec le canon 10 par l'intermédiaire de la portion de clavetage 20, seul le canon 10 se déplace à rotation par rapport à l'arbre de sortie 2, réalisant un indexage angulaire de l'ensemble canon 10 et aiguille 50 par rapport à l'ensemble arbre 2 et élément moteur 1.

Par la suite, on peut retirer l'aiguille 50 par translation selon l'axe 13 en prenant soin de ne pas déplacer angulairement le canon 10 par rapport à l'arbre 2.

Un tel retrait de l'aiguille 50 peut être souhaité notamment à des fins de maintenance ou encore, sur une chaîne de montage, après positionnement du canon d'indexage 10 sur l'arbre de sortie 2 de l'élément moteur.

On va maintenant décrire avec plus de précision la structure du canon d'indexage 10 représenté sur les figures 2, 3 et 4.

On aperçoit sur ces figures le fût 11 du canon 10, muni d'un alésage traversant 12 centré sur l'axe 13. De préférence, comme illustré sur la figure 2, l'alésage 12 est muni au niveau de son extrémité libre d'un bord d'engagement 14 élargi en forme générale de tronc de cône. Comme indiqué précédemment, I'alésage 12 peut être légèrement évasé en direction du bord d'engagement 14 précité.

La portion de clavetage 20 est formée avantageusement de deux languettes 22, 24 s'étendant sensiblement parallèlement à l'axe 13. L'enveloppe définie par les deux languettes, comme indiqué précédemment, est non symétrique de révolution par rapport à cet axe 13.

Le fût et la portion 20 de clavetage sont séparés par un disque 15. Ce disque définit la surface d'appui 16 précitée, pour l'aiguille, qui s'étend transversalement à l'axe 13.

L'enveloppe extérieure des languettes 22, 24 est pour l'essentiel formée d'une surface cylindrique 25 et d'une surface formant méplat sensiblement plane 26. Cette dernière s'étend d'une façon générale sensiblement parallèlement à l'axe 13.

La surface cylindrique 25 présente par rapport à l'axe 13 une ouverture angulaire de l'ordre de 250°.

Plus précisément, la surface formant méplat 26 se décompose avantageusement, comme représenté sur les figures, en une surface plane 27 parallèle à l'axe 13 et adjacente au disque 15 d'une part, et en une surface plane 28 convergeant vers l'axe 13 en direction de son extrémité libre d'autre part.

Les surfaces planes 27 et 28 précitées se raccordent au niveau d'une génératrice rectiligne 29 qui s'étend transversalement à l'axe 13 (voir figure 3).

Les languettes 22 et 24 sont séparées par un canal 30 sensiblement en forme de U. Le canal 30 s'étend perpendiculairement à la surface formant méplat 26 (c'est-à-dire parallèlement au plan de la figure 2 mais perpendiculairement au plan de la figure 3).

Les parois latérales 31,32 du canal 30 divergent vers l'ouverture du canal, c'est-à-dire vers l'extrémité libre des languettes 22, 24 opposée au fût 11.

Le fond 33 du canal 30, formé d'un secteur sensiblement hémi-cylindrique centré sur un axe qui s'étend perpendiculairement à la surface 27 précitée et coupe l'axe 13, est distant du disque 15.

Chaque languette 22, 24 comprend de plus, à proximité de son extrémité libre, une dent 34, 36, en saillie. Les dents 34, 36 sont sensiblement diamètralement opposées par rapport à l'axe 13 et s'étendent en saillie vers l'extérieur des languettes. Considérée en section droite dans un plan sensiblement parallèle à la surface formant méplat 26 précité, chaque dent 34, 36 a une forme généralement triangulaire dont le sommet 35, 37 est arrondi.

La face avant 38, 39 des dents 34, 36, dirigée vers l'extrémité des languettes, converge vers l'axe 13 en direction de cette extrémité libre. La face avant 38, 39 des dents est inclinée d'environ 35° par rapport à l'axe 13. La face arrière 40, 41 des dents, dirigée vers le disque 15, par contre converge vers l'axe 13 en direction du disque 15 et est inclinée d'environ 60° par rapport à l'axe 13.

Enfin, chacune des languettes 22, 24 est effilée vers son extrémité libre. Chacune des languettes se termine par un sommet arrondi 42, 43. L'extrémité effilée des languettes 22, 24 est définie sur l'extérieur par la surface avant 38, 39 des dents et sur l'intérieur par des pans 44, 45 qui divergent par rapport à l'axe 13 en direction de l'extrémité libre des languettes. Les pans 44, 45 prolongent les parois latérales 31, 32 du canal et possèdent une divergence supérieure à celle desdites parois latérales 31, 32.

L'aiguille 50 peut faire l'objet de différents modes de réalisation. Par ailleurs, la structure générale de l'aiguille est classique en soi et ne sera pas décrite par la suite.

Selon le mode de réalisation représenté sur les figures 5 et 6, le moyeu 52 de l'aiguille 50 présente un alésage 53 formé par la combinaison d'une surface cylindrique 54 et d'un méplat 55. La surface cylindrique 54 couvre un secteur angulaire de l'ordre de 250° par rapport à l'axe 57. Le méplat 55 s'étend parallèlement à la surface 57.

La section droite de l'alésage 53, considéré transversalement à l'axe 57, est sensiblement complémentaire de la section droite de la portion 20 de clavetage, en dessous des dents 34, 36.

De préférence, l'aiguille 50 est équilibrée par rapport à l'axe 57 grâce à un contrepoids 56 fixé sur le moyeu à l'opposé du corps indicateur 51 par rapport à l'axe 57.

Bien entendu, la distance séparant sur le canon d'indexage 10 la surface d'appui 16 de la base des surfaces arrières 40, 41 des dents 34, 36 doit être sensiblement égale à l'épaisseur de l'aiguille 50 considérée parallèlement à l'axe 57. Lors de l'engagement de l'aiguille 50 sur le canon 10, les languettes 22, 24 fléchissent élastiquement en rapprochement. L'engagement de l'alésage 53 sur les languettes 22, 24 est facilité par l'extrémité effilée des languettes définie par la surface convergente avant 38, 39. Dès que les dents 34, 36 ont franchi l'alésage 53, les languettes 22, 24 reprennent élastiquement leur position de repos et les dents 34, 36 immobilisent l'aiguille 50 sur le canon 10.

La pente des faces arrières 40, 41 des dents, la hauteur des dents et l'élasticité des languettes 22, 24 sont adaptées pour définir une force d'accrochage de l'aiguille 50 sur le canon 10 qui est inférieure à la force d'accrochage du canon 10 sur l'arbre de sortie 2 de l'élément moteur définie par la section de l'alésage 12.

Le canon 10 est avantageusement réalisé en polycarbonate ou en polyacétal.

Dans le cadre de la présente invention, on peut envisager de réaliser une série de canons d'indexage 10 présentant des alésages 12 de section différente et/ou des portions de clavetage 20 possédant des sections droites de dimension différente. Cette disposition permet, comme évoqué précédemment, de placer, avec utilisation d'un canon d'indexage intermédiaire approprié, différents modèles d'aiguille 50 sur un élément moteur 1 standard, ou inversement une aiguille 50 standard sur différents modèles d'élément moteur 1.

Dans un tel cas, les canons d'indexage de ladite série sont réalisés selon des couleurs différentes afin de distinguer le type d'élément moteur 1 et/ ou le type d'aiguille 50 approprié.

## Revendications

1. Dispositif indicateur à aiguille du type comprenant :
- un élément moteur (1) muni d'un arbre de sortie (2) déplacé en pivotement autour de son axe, de façon contrôlée, en fonction d'un paramètre à visualiser,
- une aiguille (50), et
- un élément intermédiaire (10) intercalé entre l'arbre de sortie (2) de l'élément moteur et l'aiguille (50) pour entrainer l'aiguille à rotation en correspondance à la rotation de l'arbre de sortie, ledit élément intermédiaire (10) comprenant un fût (11) muni d'un alésage (12) par lequel l'élément intermédiaire (10) est chassé sur l'arbre de sortie (2) de l'élément moteur, et une portion non symétrique de révolution par rapport à l'axe (13) de l'alésage (12) et destinée à coopérer avec l'aiguille (50) pour définir un indexage angulaire de celle-ci par rapport à l'arbre (2),
caractérisé par le fait que :
a) - l'élément intermédiaire à la forme d'un canon (10),
b) - l'aiguille (50) comprend un alésage (53) non symétrique de révolution, sensiblement complémentaire de la portion non symétrique de révolution prévue sur le canon (10),
c) - la portion non symétrique de révolution prévue sur le canon (10) comprend une structure élastique de clavetage (22, 24) s'étendant sensiblement parallèlement à l'axe de l'arbre (2), ladite structure élastique étant conçue pour être engagée élastiquement dans l'alésage complémentaire de l'aiguille par translation relative selon l'axe de l'arbre, et
d) - l'alésage (12) formé dans le fût du canon (10) définissant un engagement serré par friction du canon (10) sur l'arbre de sortie (2) qui correspond à une force de maintien supérieure à la force de maintien définie par la structure élastique (22, 24) dans l'alésage complémentaire (53) de l'aiguille.

2. Dispositif indicateur à aiguille selon la revendication 1, caractérisé par le fait que la partie de clavetage (20) non symétrique de révolution, du canon (10), possède une enveloppe choisie dans le groupe comprenant : un carré, un tronc à méplat, un tronc cannelé.

3. Dispositif indicateur à aiguille selon l'une des revendications 1 ou 2, caractérisé par le fait que l'enveloppe de la portion de clavetage (20) est définie par une surface principale cylindrique (25) et un méplat (26).

4. Dispositif indicateur à aiguille selon l'une des revendications 1 à 3, caractérisé par le fait que la portion de clavetage (20) est formée d'au moins deux languettes élastiques (22, 24).

5. Dispositif indicateur à aiguille selon la revendication 4, caractérisé par le fait que chaque languette élastique (22, 24) est munie à proximité de son extrémité libre d'une dent (34, 36) en saillie vers l'extérieur.

6. Dispositif indicateur à aiguille selon l'une des revendications 1 à 5, caractérisé par le fait que l'alésage (12) du fût (11) est légèrement tronconique, évasé vers son extrémité libre.

7. Dispositif indicateur à aiguille selon l'une des revendications 1 à 6, caractérisé par le fait que le canon possède une surface d'appui (16) pour l'aiguille, qui s'étend perpendiculairement à l'axe (13) de l'alésage.

8. Dispositif indicateur à aiguille selon l'une des revendications 1 à 7, caractérisé par le fait que le canon (10) est réalisé en matière plastique.

9. Canon d'indexage pour le dispositif indicateur conforme à l'une des revendications 1 à 8, caractérisé par le fait qu'il comprend un fût (11) muni d'un alésage (12) par l'intermédiaire duquel le canon (10) peut être chassé sur l'arbre de sortie (2) d'un élément moteur et une portion de clavetage d'une aiguille, non symétrique de révolution par rapport à l'axe (13) de l'alésage (12), pour entrainer l'aiguille à rotation en correspondance à la rotation de l'arbre de sortie, et dans lequel la portion non symétrique de révolution prévue sur le canon (10) comprend une structure élastique (22, 24) s'étendant sensiblement parallèlement à l'axe de l'alésage (12), ladite structure élastique étant conçue pour être engagée élastiquement dans l'alésage complémentaire d'une aiguille par translation relative selon l'axe de l'alésage, et l'alésage (12) formé dans le fût du canon (10) définit un engagement serré par friction du canon (10) sur l'arbre de sortie (2) d'un élément moteur, qui correspond à une force de maintien supérieure à la force de maintien définie par la structure élastique (22, 24) dans l'alésage complémentaire (53) de l'aiguille.

10. Canon d'indexage selon la revendication 9, caractérisé par le fait que la portion de clavetage (20) est formée d'au moins deux languettes élastiques (22, 24) munies chacune, à proximité de leur extrémité libre, d'une dent à saillie (34, 36).

## Patentansprüche

1. Anzeigevorrichtung mit einem Zeiger der Bauart mit:
- einem Antriebselement (1) mit einer Abtriebswelle (2), die um ihre Achse in Abhängigkeit von einer Anzeigegröße gesteuert drehbar ist,
- einer Anzeigenadel (50) und
- einem Zwischenelement (10), das zwischen die Abtriebswelle (2) des Antriebselementes und die Anzeigenadel (50) eingefügt ist, um die Anzeigenadel entsprechend der Drehung der Abtriebswelle in Drehung zu versetzen, wobei das Zwischenelement (10) einen Schaft (11) mit einer Bohrung (12) aufweist, durch welche das Zwischenelement (10) auf die Abtriebswelle (2) des Antriebselements aufgesteckt ist, sowie einen bezüglich der Achse (13) der Bohrung (12) nicht rotationssymmetrischen Abschnitt, der mit der Anzeigenadel (50) zusammenwirkt, um eine Winkel-Indexierung derselben bezüglich der Abtriebswelle (2) zu bestimmen,
dadurch gekennzeichnet, daß
a) das Zwischenelement die Form einer Hülse (10) hat,
b) die Anzeigenadel (50) eine nicht rotationssymmetrische Bohrung (53) aufweist, die zu dem auf der Hülse (10) vorgesehenen, nicht rotationssymmetrischen Abschnitt ungefähr komplementär ist,
c) der auf der Hülse (10) vorgesehene, nicht rotationssymmetrische Abschnitt eine elastische Keilstruktur (22, 24) aufweist, die sich ungefähr parallel zur Achse der Welle (2) erstreckt, wobei die elastische Struktur elastisch in die komplementäre Bohrung der Anzeigenadel durch Verschiebung längs der Wellenachse einbringbar ist, und
d) die im Schaft der Hülse (10) ausgebildete Bohrung (12) durch Reibung der Hülse (10) auf der Abtriebswelle (2) einen Klemm-Eingriff bestimmt, der einer Haltekraft entspricht, welche größer ist als die durch die elastische Struktur (22, 24) in der komplementären Bohrung (53) der Anzeigenadel bestimmte Haltekraft.

2. Anzeigevorrichtung mit einem Zeiger nach Anspruch 1, dadurch gekennzeichnet, daß der nicht rotationssymmetrische Keilabschnitt (20) der Hülse (10) eine Kontur hat, die aus der Gruppe ausgewählt ist, die folgendes beinhaltet: ein Viereck, einen abgeflachten Schaft, einen gerillten Schaft.

3. Anzeigevorrichtung mit einem Zeiger nach einem der Ansprüche 1 oder 2, dadurch gekennzeichnet, daß die Kontur des Keilabschnittes (20) von einer im wesentlichen zylindrischen Oberfläche (25) und einer Abflachung (26) begrenzt ist.

4. Anzeigevorrichtung mit einem Zeiger nach einem der Ansprüche 1 bis 3, dadurch gekennzeichnet, daß der Keilabschnitt (20) von mindestens zwei elastischen Zungen (22, 24) gebildet ist.

5. Anzeigevorrichtung mit einem Zeiger nach Anspruch 4, dadurch gekennzeichnet, daß jede elastische Zunge (22, 24) nahe ihrem freien Ende mit einem nach außen gerichteten Zahn (34, 36) versehen ist.

6. Anzeigevorrichtung mit einem Zeiger nach einem der Ansprüche 1 bis 5, dadurch gekennzeichnet, daß die Bohrung (12) des Schaftes (11) leicht konisch zum freien Ende hin geweitet ist.

7. Anzeigevorrichtung mit einem Zeiger nach einem der Ansprüche 1 bis 6, dadurch gekennzeichnet, daß die Hülse eine Anlagefläche (16) für die Anzeigenadel aufweist, die sich senkrecht zu der Achse (13) der Bohrung erstreckt.

8. Anzeigevorrichtung mit einem Zeiger nach einem der Ansprüche 1 bis 7, dadurch gekennzeichnet, daß die Hülse (10) in Kunststoff ausgeführt ist.

9. Indexierungshülse für die Anzeigevorrichtung nach einem der Ansprüche 1 bis 8, dadurch gekennzeichnet, daß sie einen Schaft (11) mit einer Bohrung (12), mittels derer die Hülse (10) auf die Abtriebswelle (2) eines Antriebselementes aufsteckbar ist, und einen Keilabschnitt der Anzeigenadel aufweist, der bezüglich der Achse (13) der Bohrung (12) nicht rotationssymmetrisch ist, um die Anzeigenadel entsprechend der Drehung der Abtriebswelle in Drehung zu versetzen, und bei welcher der auf der Hülse vorgesehene, nicht rotationssymmetrische Abschnitt eine elastische Struktur (22, 24) aufweist, die sich ungefähr parallel zur Achse der Bohrung (12) erstreckt, wobei die elastische Struktur durch Verschiebung relativ zur Bohrungsachse elastisch in die komplementäre Bohrung der Anzeigenadel einbringbar ist, und wobei die im Schaft der Hülse (10) ausgebildete Bohrung (12) durch Reibung der Hülse (10) auf der Abtriebswelle (2) des Antriebselementes einen Klemm-Eingriff bestimmt, der einer Haltekraft entspricht, welche größer ist als die durch die elastische Struktur (22, 24) in der komplementären Bohrung (53) der Anzeigenadel bestimmte Haltekraft.

10. Indexierungshülse nach Anspruch 9, dadurch gekennzeichnet, daß der Keilabschnitt (20) von mindestens zwei elastischen Zungen (22, 24) gebildet ist, die jeweils nahe ihren Enden mit einem abstehenden Zahn (34, 36) versehen sind.

## Claims

1. Indicating device having a needle, of the type comprising:
- a driving element (1) equipped with a driven shaft (2) displaced pivotally about its axis in controlled manner as a function of a parameter to be displayed,
- a needle (50), and
- an intermediate element (10) placed between the driven shaft (2) of the driving element and the needle (50) to drive the needle in rotation in a manner corresponding to the rotation of the driven shaft, the said intermediate element (10) comprising a shaft (11) equipped with a bore (12) by means of which the intermediate element (10) is driven on the driven shaft (2) by the driving element, and a section which is asymmetrical in rotation with respect to the axis (13) of the bore (12) and is intended to cooperate with the needle (50) to define an angular pointing of the latter with respect to the shaft, characterized in that:
a) - the intermediate element is in the shape of a barrel (10),
b) - the needle (50) comprises a bore (53) which is asymmetrical in rotation and substantially complementary with the section on the barrel (10) which is asymmetrical in rotation,
c) - the section on the barrel (10) which is asymmetrical in rotation comprises a resilient wedging structure (22, 24) extending substantially parallel to the axis of the shaft (2), the said resilient structure being designed to engage resiliently in the complementary bore of the needle by a relative translational movement along the axis of the shaft, and
d) - the bore (12) formed in the shaft of the barrel (10) defining a clamped frictional engagement of the barrel (10) on the driven shaft (2) which corresponds to a holding force greater than the holding force defined by the resilient structure (22, 24) in the complementary bore (53) of the needle.

2. Indicating device having a needle, according to Claim 1, characterized in that the wedging section (20), which is asymmetrical in rotation, of the barrel (10) has a casing which is selected from the group comprising a square, a flattened section and a grooved section.

3. Indicating device having a needle, according to one of Claims 1 or 2, characterized in that the casing of the wedging section (20) is defined by a principal cylindrical surface (25) and a flat (26).

4. Indicating device having a needle, according to one of Claims 1 to 3, characterized in that the wedging section (20) is formed by at least two resilient tongues (22, 24).

5. Indicating device having a needle, according to Claim 4, characterized in that each resilient tongue (22, 24) is equipped in the vicinity of its free end with a tooth (34, 36) projecting outwards.

6. Indicating device having a needle, according to one of Claims 1 to 5, characterized in that the bore (12) of the shaft (11) is slightly frustoconical, being widened towards its free end.

7. Indicating device having a needle, according to one of Claims 1 to 6, characterized in that the barrel has a bearing surface (16) for the needle, extending perpendicularly to the axis (13) of the bore.

8. Indicating device having a needle, according to one of Claims 1 to 7, characterized in that the barrel (10) is made of plastic material.

9. Pointing barrel for the indicating device according to one of Claims 1 to 8, characterized in that it comprises a shaft (11) equipped with a bore (12) by means of which the barrel (10) may be driven on the driven shaft (2) of a driving element and a wedging section of a needle, which is asymmetrical in rotation with respect to the axis (13) of the bore (12), to drive the needle in rotation in a manner corresponding to the rotation of the driven shaft, and in which the section on the barrel (10) which is asymmetrical in rotation comprises a resilient structure (22, 24) extending substantially parallel to the axis of the bore (12), the said resilient structure being designed to engage resiliently in the complementary bore of a needle by a relative translational movement along the axis of the bore, and the bore (12) formed in the shaft of the barrel (10) defines a clamped frictional engagement of the barrel (10) on the driven shaft (2) of a driving element which corresponds to a holding force greater than the holding force defined by the resilient structure (22, 24) in the complementary bore (53) of the needle.

10. Pointing barrel according to Claim 9, characterized in that the wedging section (20) is formed by at least two resilient tongues (22, 24) each equipped in the vicinity of their free end with a projecting tooth (34, 36).
